(19) Europäisches Patentamt / European Patent Office / Office européen des brevets

(11) **EP 3 326 255 B1**

(12) **EUROPÄISCHE PATENTSCHRIFT**

(45) Veröffentlichungstag und Bekanntmachung des Hinweises auf die Patenterteilung:
**25.02.2026 Patentblatt 2026/09**

(21) Anmeldenummer: **16744331.6**

(22) Anmeldetag: **13.07.2016**

(51) Internationale Patentklassifikation (IPC):
*H02J 3/01* (2026.01)    *H02J 3/38* (2026.01)
*H02J 3/26* (2026.01)    *G01R 27/00* (2006.01)

(52) Gemeinsame Patentklassifikation (CPC):
**H02J 3/0014; H02J 3/381;** G01R 19/0084;
H02J 2101/28; Y02E 10/72

(86) Internationale Anmeldenummer:
**PCT/EP2016/066587**

(87) Internationale Veröffentlichungsnummer:
**WO 2017/016870 (02.02.2017 Gazette 2017/05)**

(54) **VERFAHREN UND VORRICHTUNG ZUM ERFASSEN EINER ELEKTRISCHEN SPANNUNG IN EINEM VERSORGUNGSNETZ**

METHOD AND DEVICE FOR DETECTING AN ELECTRICAL VOLTAGE IN A SUPPLY NETWORK

PROCÉDÉ ET DISPOSITIF DE DÉTECTION D'UNE TENSION ÉLECTRIQUE DANS UN RÉSEAU DE DISTRIBUTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.07.2015 DE 102015112155**

(43) Veröffentlichungstag der Anmeldung:
**30.05.2018 Patentblatt 2018/22**

(73) Patentinhaber: **Wobben Properties GmbH
26607 Aurich (DE)**

(72) Erfinder:
- **STRAFIEL, Christian
  26607 Aurich (DE)**
- **ENGELKEN, Sönke
  28215 Bremen (DE)**
- **MACKENSEN, Ingo
  26607 Aurich (DE)**
- **GERTJEGERDES, Stefan
  26603 Aurich (DE)**
- **Meli, William
  22457 Hamburg (DE)**

(74) Vertreter: **Eisenführ Speiser
Patentanwälte Rechtsanwälte PartGmbB
Postfach 10 60 78
28060 Bremen (DE)**

(56) Entgegenhaltungen:
WO-A1-2009/056158    DE-A1- 102011 084 910
US-A1- 2012 150 468

- BEIDES H M ET AL: "DYNAMIC STATE ESTIMATION OF POWER SYSTEM HARMONICS USING KALMAN FILTER METHODOLOGY", IEEE TRANSACTIONS ON POWER DELIVERY, IEEE SERVICE CENTER, NEW YORK, NY, US, vol. 6, no. 4, 1 October 1991 (1991-10-01), pages 1663 - 1670, XP000271663, ISSN: 0885-8977, DOI: 10.1109/61.97705

**Beschreibung**

Die folgende Erfindung betrifft ein Verfahren zum Einspeisen elektrischen Stroms in ein elektrisches, dreiphasiges Versorgungsnetz. Außerdem betrifft die vorliegende Erfindung eine Windenergieanlage, in der ein solches Verfahren implementiert ist.

Zum Einspeisen elektrischer Leistung in ein elektrisches Versorgungsnetz, das üblicherweise dreiphasig aufgebaut ist, ist es erforderlich, die Spannung nach Betrag und Phase zu erfassen, was auch das Erfassen oder die Kenntnis der Frequenz impliziert. Die Anforderungen, um solche Spannungen zu erfassen werden zunehmend höher, was insbesondere auch die Geschwindigkeit zum Erfassen von Veränderungen betrifft. Ein Verfahren zum schnellen und präzisen Erfassen der Spannung nach Betrag und Phase ist beispielsweise in dem US-Patent 8,981,755 beschrieben.

Darüber hinaus ist es besonders mit Windenergieanlagen, die mit einem Vollumrichterkonzept arbeiten, also elektrische Leistung der Windenergieanlage vollständig über einen Wechselrichter ins Netz einspeisen, möglich, die eingespeiste elektrische Leistung in ihrer Qualität an Unsymmetrien im Netz gezielt anzupassen.

Ein Beispiel für eine Einspeisung eines unsymmetrischen dreiphasigen Stroms ist in der US-Anmeldung US 2013/0141951 beschrieben. Dort wird die Methode der symmetrischen Komponenten verwendet. Dabei werden Stromkomponenten des Mitsystems und Stromkomponenten des Gegensystems unabhängig voneinander erzeugt und dann zu dem gewünschten unbalancierten Strom überlagert und eingespeist.

Die Qualität auch einer solchen Einspeisung hängt letztlich auch von der Qualität der Erfassung von Unsymmetrien ab. Dabei ist zu beachten, dass bisher das Konzept in Versorgungsnetzen so funktionierte, dass Großkraftwerke mit dominanten, direkt mit dem Netz gekoppelten Synchrongeneratoren die Qualität und insbesondere die Symmetrie der Spannung im Grunde durch die Dominanz des Stroms des Synchrongenerators bestimmt haben. Es gibt zwar schon seit längerem erste Überlegungen, gezielt Unsymmetrien zu kompensieren, wie das beispielsweise dem US-Patent 6,924,627 zu entnehmen ist, gleichwohl ist das oben beschriebene Prinzip aufrecht erhalten worden, nicht zuletzt auch deshalb, weil die beschriebenen Synchrongeneratoren der Großkraftwerke solche Kompensationen nur passiv durch ihre Bauart, nicht jedoch durch aktive Regelung leisten können.

Es kommt hinzu, dass in modernen Energiesystemen Erzeugungseinheiten und Verbraucher in zunehmendem Maße über Frequenzumrichter bzw. Gleichrichter an das Übertragungs- oder Verteilungsnetz angeschlossen sind. Durch die schaltenden Komponenten dieser leistungselektronischen Systeme entsteht eine Verunreinigung der im idealen Fall sinusförmigen 50 Hz- oder 60 Hz-Wechselspannung durch Oberschwingungen im Frequenzbereich bis zu etwa 10 kHz. Diese Oberschwingungen wirken belastend auf verschiedene Betriebsmittel in den Energiesystemen und werden daher bei zu hohem Aufkommen durch aktive oder passive Filter bedämpft.

Windenergieanlagen stellen in einigen Energiesystemen schon einen signifikanten Teil der erzeugten Energie zur Verfügung. Oftmals, teilweise überwiegend sind sie durch Frequenzumrichter mit dem Netz verbunden und tragen somit im schlimmsten Fall ebenfalls zu Oberschwingungen im Netz bei.

Das Dokument WO 2009/056158 A1 beschreibt ein Verfahren zum Schätzen einer Wechselspannung. Dabei werden Betrag und Phase einer Sinusfunktion mit einer Grundwelle und wenigstens einer Oberwellle mit einem adaptiven Filter bzw. einem Beobachter geschätzt. Das Verfahren kann auf alle drei Phasen der Netzspannung separat angewendet werden.

Das Dokument US 2012/150468 A1 beschreibt ein Verfahren zum Schätzen der dreiphasigen Spannung zur Synchronisation mit dem Versorgungsnetz.

Das deutsche Patent- und Markenamt hat in der Prioritätsanmeldung zu vorliegender PCT-Anmeldung folgenden Stand der Technik recherchiert: DE 100 32 447 A1, US 2012/0150468 A1, US 2014/0307488 A1, EP 2 223 405 B1, Azam Bagheri et al. "Detection of Grid Voltage Fundamental and Harmonic Components Using Kalman Filter and Generalizied Averaging Method", Ming Sun et al. "Extended Kalman Filter Based Grid Synchronization in the Presence of Voltage Unbalance for Smart Grid" und Robert R. Bitmead et al. "A Kalman Filtering Approach to Short-Time Fourier Analysis".

Der vorliegenden Erfindung liegt somit die Aufgabe zugrunde, zumindest eines dieser genannten Probleme zu adressieren, besonders Verbesserungen vorzuschlagen. Insbesondere soll eine Lösung vorgeschlagen werden, die Möglichkeiten einer Netzverbesserung einschließlich einer Kompensation von Oberschwingungen im Netz schafft. Zumindest soll eine zu bisher bekannten Lösungen alternative Lösung vorgeschlagen werden.

Erfindungsgemäß wird ein Verfahren gemäß Anspruch 1 vorgeschlagen. Demnach wird die elektrische Spannung in dem elektrischen, dreiphasigen Versorgungsnetz nach Betrag und Phase für eine Grundschwingung und wenigstens eine Oberschwingung erfasst. Dabei ist unter einem elektrischen Versorgungsnetz bspw. auch ein elektrisches Verteilungsnetz zu verstehen. Es geht grundsätzlich um ein elektrisches Netzwerk, an dem viele Stromerzeuger und Stromverbraucher angeschlossen sind.

Zunächst wird eine elektrische, dreiphasige Spannung des Versorgungsnetzes gemessen.

Die gemessene elektrische dreiphasige Spannung wird dann in Polarkoordinaten transformiert, so dass sich ein umlaufender Spannungszeiger für die Grundschwingung ergibt. Dieser wird als gemessener Referenzzeiger bezeichnet und entsprechend auch nachfolgend verwendet. Die Transformation kann beispielsweise so erfolgen, wie es auch in dem US-Patent 8,981,755 geschieht.

Außerdem werden Werte jeweils wenigstens eines Spannungszeigers für die Grundschwingung und wenigstens eines Spannungszeigers einer zu erfassender Oberschwingung mit Hilfe eines Zustandsbeobachters beobachtet. Dies bezeichnet einen Zustandsbeobachter im regelungstechnischen Sinne. Die beobachteten Werte werden nun in Abhängigkeit des gemessenen Referenzzeigers nachgeführt.

Mit anderen Worten wird ein Beobachtermodell zu Grunde gelegt, das zur Darstellung der Netzspannung wenigstens eine Grundschwingung und wenigstens eine Oberschwingung zu Grunde legt und jeweils wenigstens einen Spannungszeiger verwendet. Das gemessene System wird mit einem Spannungszeiger für die Grundschwingung dargestellt, wobei durch stetiges Messen und Transformieren dieser Spannungszeiger sich auch dem Betrag nach und der Phase nach ändern kann.

Der Vergleich zur Nachführung des Beobachters erfolgt insbesondere über Vergleich dieses Messwertes in Polarkoordinaten, also der Werte dieses einen umlaufenden Spannungszeigers aus der Messung mit der Summe sämtlicher Spannungszeiger, die der Beobachter zu Grunde legt.

Vorzugsweise arbeitet der Zustandsbeobachter in Abhängigkeit einer erfassten Netzfrequenz, wobei die erfasste Netzfrequenz in den Zustandsbeobachter als Eingangsgröße eingegeben wird. Demnach wird vorgeschlagen, dass der Zustandsbeobachter die Netzfrequenz nicht als zu beobachtenden und ggf. nachzuführenden Zustand beobachtet, sondern den erfassten und ihm eingegebenen Wert für die Frequenz als gegeben annimmt und zu Grunde legt. Dadurch kann eine Stabilitätsverbesserung oder anders ausgedrückt eine Stabilisierung der Beobachtung erreicht werden, weil diese Frequenz, die sich auf jeden umlaufenden beobachteten Spannungszeiger auswirkt bzw. eine charakteristische Größe eines solchen Spannungszeigers ist, eine feste Größe darstellt. Der Beobachter kann sich bei der Beobachtung auf Betrag und Phase konzentrieren und eine möglicherweise störende oder sogar stabilitätsgefährdende Wechselwirkung zwischen Frequenz einerseits und Betrag und Phase andererseits wird dadurch ausgeschlossen.

Gemäß einer Ausführungsform wird vorgeschlagen, dass der Zustandsbeobachter die Werte der Spannungszeiger mit Hilfe einer aktuellen Beobachtermatrix beobachtet und die aktuelle Beobachtermatrix aus mehreren vorberechneten Beobachtermatrizen in Abhängigkeit der erfassten Netzfrequenz ausgewählt wird. Es wird darauf hingewiesen, dass hier die Begriffe Matrix und Matrize synonym verwendet werden. Eine solche Beobachtermatrix stellt eine bekannte Komponente in einer Beobachterstruktur dar und hat im Grunde die Aufgabe, die beobachteten Zustände anhand von Vergleichsmesswerten nachzuführen. Als Vergleichsmesswerte dient hier der Referenzzeiger. Um variierende Frequenzen bei der Beobachtung hier zu berücksichtigen, kann die Berechnung frequenzabhängiger Beobachtermatrizen sehr aufwändig sein. Der Aufwand kann u.U. die verfügbare Rechenkapazität eines Mikrocontrollers in einem vorgegebenen Zeitschritt überschreiten, so dass eine Berechnung nicht mit der geforderten Taktrate möglich ist. Durch die Verwendung zuvor berechneter Beobachtermatrizen, die dann frequenzabhängig, insbesondere also von einer jeweils aktuell erfassten Frequenz ausgewählt werden, kann dieser Aufwand reduziert werden. Mitunter wird hierdurch eine solche Berücksichtigung der Frequenzvariation überhaupt erst möglich. Bei Frequenzen, für die, was auch eine Frage der Genauigkeit der Frequenzerfassung ist, keine vorbestimmte Beobachtermatrix vorliegt, kann diese durch Interpolation zwischen zwei Beobachtermatrizen bestimmt werden.

Vorzugsweise wird als Zustandsbeobachter ein Kalman-Filter verwendet. Insoweit kann bei der vorliegenden Beobachtung der Zustände auch von einer Filterung gesprochen werden bzw. der Zustandsbeobachter als Filter bezeichnet werden. Durch die Verwendung eines Kalman-Filters ist die Beobachtung bzw. die Filterung besonders gut geeignet, Störungen, besonders Messrauschen zu berücksichtigen, nämlich herauszufiltern.

Gemäß einer Ausführungsform wird vorgeschlagen, dass ein Gleichanteil, und für die Grundschwingung und für jede zu erfassende Oberschwingung der zu erfassenden elektrischen Spannung jeweils ein Mitsystem und ein Gegensystem durch den Zustandsbeobachter erfasst werden. Dadurch kann durch den Zustandsbeobachter auch eine Unsymmetrie der dreiphasigen Spannung berücksichtig und erfasst werden. Selbst wenn keine nennenswerte Unsymmetrie vorhanden sein sollte, was vor der Messung nicht bekannt sein muss, kann eine solche Erfassung auch eines Gegensystems durchgeführt werden. Gegebenenfalls wird sich der Anteil des Gegensystems als entsprechend klein ergeben. Bei dieser Erfassung von Mitsystem und Gegensystem wird somit eine Betrachtung im Sinne der Methode der symmetrischen Komponenten zu Grunde gelegt.

Vorzugsweise werden für den Gleichanteil ein Spannungszeiger, und für die Grundschwingung und für jede zu erfassende Oberschwingung jeweils zwei Spannungszeiger zu Grunde gelegt und deren Werte beobachtet, so dass nämlich jeweils ein Spannungszeiger für ein Mitsystem und einer für ein Gegensystem angenommen wird. Auch für den Gleichanteil kann es sinnvoll sein, zwei Werte, nämlich den Real- und den Imaginärteil des Spannungszeigers anzunehmen, weil hier zumindest formelmäßig bei der Anwendung der Methode der symmetrischen Komponenten auch ein Zeiger berechnet werden kann. Vorzugsweise werden sehr viele Oberschwingungen erfasst, beispielsweise 25 Oberschwingungen, also eine Erfassung bis zur 25. Harmonischen. In diesem Fall ergeben sich, wenn die erste Harmonische die Grundschwingung ist, 51 Zeiger und damit 102 Werte.

Gemäß einer Ausführungsform ist das Verfahren zum Erfassen der elektrischen Spannung dadurch gekennzeichnet, dass die Messung der elektrischen, dreiphasigen Spannung des Versorgungsnetzes an einem an das elektrische Versorgungsnetz angeschlossenen Transformator erfolgt, der häufig vereinfachend auch als Trafo bezeichnet wird. An einem solchen Transformator, insbesondere an einem solchen, über den in das elektrische Versorgungsnetz elektrischer Strom eingespeist wird, kann auf einfache und zuverlässige Weise gemessen werden.

Besonders vorteilhaft ist die Messung an einem solchen Transformator dann, wenn über diesen Transformator elektrischer Strom eingespeist wird und die Einspeisung die Messung bzw. Erfassung der elektrischen Spannung des elektrischen Versorgungsnetzes berücksichtigt. Besonders wenn abhängig der beobachteten Oberschwingungen ein zumindest teilweise kompensierender Strom über diesen Transformator eingespeist wird, können hier Verfälschungen vermieden werden.

Vorzugsweise erfolgt die Messung an der Seite des Transformators, die elektrisch einer Windenergieanlage zugewandt ist, die über diesen Transformator in das elektrische Versorgungsnetz einspeist. Besonders dann kann diese Windenergieanlage diese erfassten Spannungswerte, insbesondere beobachteten Oberschwingungen berücksichtigen und die Einspeisung des elektrischen Stroms entsprechend anpassen. Insbesondere kann sie den einzuspeisenden elektrischen Strom so formen, dass eine Kompensation oder zumindest Reduzierung von beobachteten Oberschwingungen der Netzspannung möglich ist.

Erfindungsgemäß wird die Transformation der gemessenen Spannung in Polarkoordinaten mit Hilfe der Clarke-Transformation unter Annahme der Nullsystemfreiheit der Spannung durchgeführt. Dies entspricht auch der Transformation, die in dem oben genannten US-Dokument (US 8,981,755) beschrieben ist. Es wird hierbei davon ausgegangen, dass kein Nullsystem vorliegt, was auch bei der Anwendung der Theorie der symmetrischen Komponenten eine häufige Annahme ist. Die Annahme der Nullsystemfreiheit schließt die Annahme der Freiheit von Gleichanteilen jedoch nicht zwangsläufig mit ein. Vielmehr können im Drehstromnetz pro Phase verschiedene Gleichanteile vorliegen, sodass sich diese nach der Transformation auch in den Mit- und Gegensystemanteilen wiederfinden.

Bei dem erfindungsgemäßen Verfahren wird elektrischer Strom in ein elektrisches, dreiphasiges Versorgungsnetz eingespeist und dieses Verfahren umfasst auch den folgenden Schritt:

- Erzeugen eines elektrischen Stroms zum Einspeisen in das elektrische Versorgungsnetz, wobei der elektrische Strom eine Kompensationsstromkomponente beinhaltet, um die wenigstens eine erfasste Oberschwingung zu reduzieren.

Das Verfahren setzt also zunächst auch ein elektrisches, dreiphasiges Versorgungsnetz voraus, das auch das oben erläuterte Verfahren zum Erfassen elektrischer Spannung in einem solchen elektrischen, dreiphasigen Versorgungsnetz zu Grunde legt. Es kann also auch hier ein elektrisches Verteilungsnetz mit umfasst sein, um nur ein Beispiel zu nennen.

Somit wird auch die elektrische Spannung durch ein oben beschriebenes Verfahren erfasst. Das beinhaltet entsprechend auch das Erfassen, nämlich Beobachten von Werten wenigstens einer Oberschwingung der Spannung. Damit liegt ein Wert, nämlich nach Amplitude und Phase für eine solche Oberschwingung vor und kann nun verwendet werden, um eine solche erfasste Oberschwingung zumindest zu reduzieren, idealerweise vollständig zu kompensieren. Der einzuspeisende elektrische Strom beinhaltet dafür eine Kompensationsstromkomponente, die somit entsprechend wenigstens eine Oberschwingung beinhaltet. Insbesondere umfasst der Strom also eine Grundkomponente oder Grundschwingung, um nämlich entsprechende Leistung in das elektrische Versorgungsnetz einzuspeisen. Dieser Grundschwingung, also auch einem solchen idealisierten Verlauf, wird nun eine Kompensationsstromkomponente überlagert, also im elektrischen Sinne addiert. Diese Kompensationsstromkomponente soll die erfassten Oberschwingungen oder zumindest einen Teil davon reduzieren.

Gemäß einer Ausführungsform wird vorgeschlagen, dass die Kompensationsstromkomponente wenigstens eine Stromoberschwingung aufweist und eine Stromoberschwingung jeweils durch eine Amplitude und eine Phase und in Abhängigkeit der beobachteten Oberschwingungen der erfassten Spannung bestimmt wird. Die Beobachtung der Oberschwingungen der Spannung liefert somit Informationen und zwar eine klar definierte Beschreibung dieser Oberschwingung oder Oberschwingungen der Spannung. Die Kompensationsstromkomponente wird dann vorzugsweise ähnlich aufgebaut. Die Kompensationsstromkomponente weist also beispielsweise zu einer erfassten Spannungsoberschwingung eine entsprechende Stromoberschwingung auf. Die Amplitude der Stromoberschwingung kann in einem vorbestimmten Verhältnis oder zumindest Bezug zu der Oberschwingung der Spannung stehen. Außerdem wird eine Phase entsprechend so eingestellt, dass die Kompensation oder zumindest Reduzierung vorgenommen werden kann.

Vorzugsweise werden bei der Erfassung der Spannung zu jeder Oberschwingung ein Mit- und ein Gegensystem erfasst. Vorzugsweise weist entsprechend auch die entsprechende Stromoberschwingung ein Mit- und ein Gegensystem bzw. eine Mit- und eine Gegensystemkomponente auf. Auch hier kann dann jeweils eine Amplitude und Phase für die Stromoberschwingung bestimmt werden. Es kommt aber auch in Betracht, dass nur die Mitsystemkomponente betrachtet wird und insbesondere kommt auch in Betracht, dass die Kompensationsstromkomponente grundsätzlich nur jeweils eine Komponente zu jeder Stromoberschwingung bestimmt und insoweit die der Betrachtung der symmetrischen Komponenten zu Grunde liegende Unsymmetrie unberücksichtigt lässt. Hintergrund hierbei ist, dass die Betrachtung von Mit- und Gegensystem für den Beobachter sinnvoll sein kann, um dessen Gesamtfunktionalität und Gesamtqualität und Genauigkeit zu gewährleisten. Häufig kann dann aber ausreichend sein, nur die Mitsystemkomponente zu betrachten und beim Einspeisen zu generieren.

Es wird hier nochmals darauf hingewiesen, dass die Oberschwingung als auch die Stromoberschwingung jeweils eine Oberschwingung einer Ordnung meint und mehrere Oberschwingungen jeweils eine Oberschwingung aber mit unterschiedlichen Frequenzen bezeichnet.

Eine weitere Ausführungsform schlägt vor, dass jeweils eine Amplitude einer Stromoberschwingung an der Kompensationsstromkomponente über einen Regler eingestellt wird. Der Regler erhält hier als Eingangssignal eine Regeldifferenz zwischen Spannungssollwert und beobachteten Spannungsistwert der betreffenden Oberschwingung der erfassten Spannung. Im einfachsten Fall bedeutet das, dass der Spannungssollwert den Wert 0 hat, schließlich soll die Oberschwingung auf 0 reduziert werden. In bestimmten Fällen kann es natürlich auch sinnvoll sein, hier nicht den Wert 0 anzusetzen. Dieser Differenzwert, was hier als Regeldifferenz bezeichnet wird, wird dann zwischen Spannungssollwert und Spannungsistwert der betreffenden Oberschwingung auf den Regler gegeben. Das kann beispielsweise ein PID-Regler, ein PI-Regler oder ein PD-Regler sein. Im einfachsten Fall wird ein P-Regler verwendet und die erfasste Spannungsdifferenz führt dann zu einer Amplitude der Stromoberschwingung entsprechend dieses Faktors, der natürlich auch die unterschiedlichen Einheiten zwischen Spannung und Strom berücksichtigt. Hierdurch, also bei einem reinen P-Regler, wird dann die betreffende Oberschwingung der Spannung wohl nicht vollständig ausgeregelt werden können.

Um diese Oberschwingung der Spannung vollständig auszuregeln wird beispielsweise ein PID-Regler vorgeschlagen. Es ist aber dabei zu beachten, dass vorher sichergestellt werden sollte, dass auch ausreichend Stellenergie vorhanden ist. Dann kann es gelingen, mit einem solchen PID-Regler die betreffende Oberschwingung der Spannung vollständig oder nahezu vollständig auszuregeln. Ist nicht ausreichend Stellenergie vorhanden, könnte der Regler dann in eine Begrenzung gehen.

Gegebenenfalls kann ein PD-Regler eine Dynamik schaffen, ohne den Anspruch einer vollständigen Ausregelung zu haben.

Außerdem wird eine Windenergieanlage gemäß dem zweiten unabhängigen Anspruch orgeschlagen, die einen Wechselrichter beinhaltet. Mit der Windenergieanlage kann dann also ein solcher Strom eingespeist werden und somit nicht nur Energie in das elektrische Versorgungsnetz eingespeist werden, sondern auch eine Kompensation oder Reduzierung von Oberschwingungen der Spannungen vorgenommen werden. Entsprechend ist die Windenergieanlage zum Durchführen des Verfahrens ausgebildet. Außerdem kann das oben beschriebene Verfahren zur Bestimmung von Oberschwingungen der Netzspannung sinngemäß auch zur Bestimmung von Oberschwingungen im elektrischen Strom verwendet werden. Dies wird hiermit auch erfindungsgemäß vorgeschlagen.

Die Erfindung wird nun nachfolgend exemplarisch anhand von Ausführungsbeispielen und unter Bezugnahme auf die begleitenden Figuren näher erläutert.

Figur 1    zeigt schematisch eine Windenergieanlage in einer perspektivischen Darstellung.
Figur 2    zeigt eine vereinfachte Struktur zum Erläutern eines Verfahrens zum Erfassen der elektrischen Spannung gemäß einer Ausführungsform.
Figur 3    zeigt einen Funktionsblock der Figur 2 in einer detaillierteren Struktur.
Figur 4    zeigt schematisch eine Anordnung zum Einspeisen elektrischen Stroms mittels einer Windenergieanlage in ein elektrisches Versorgungsnetz gemäß einer Ausführungsform der Erfindung.

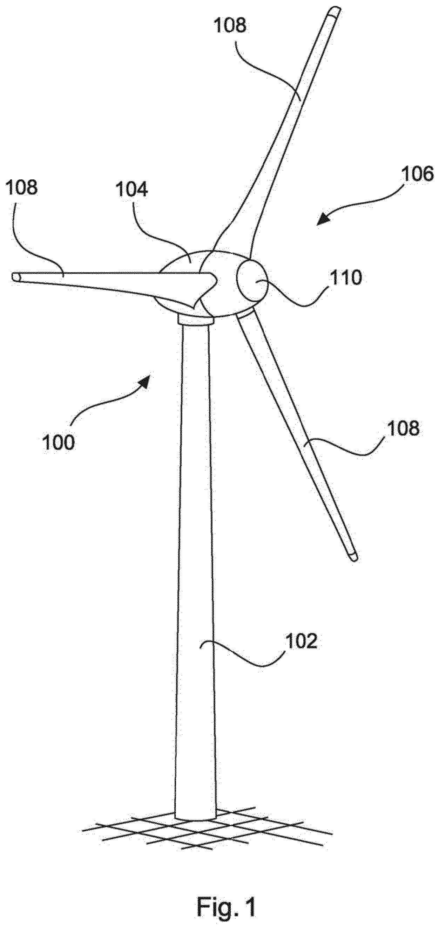

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

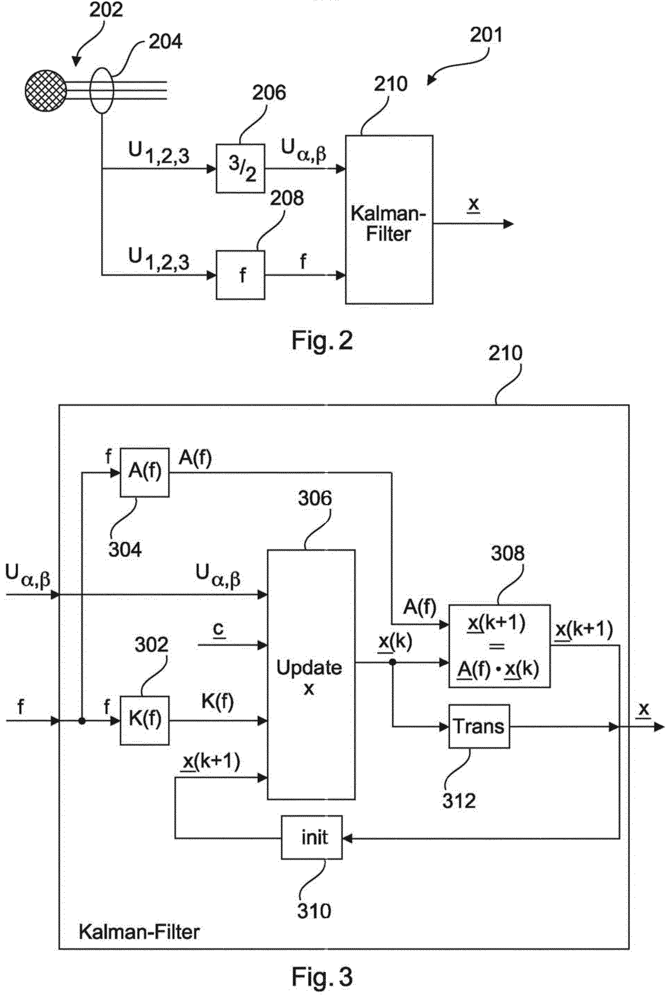

Figur 2 zeigt eine Messanordnung 201 zum Erfassen einer elektrischen Spannung in einem elektrischen, dreiphasigen, schematisch dargestellten Versorgungsnetz 202. Demnach wird mit einem Messaufnehmer 204 die elektrische Spannung $U_{1,2,3}$ dreiphasig gemessen. Die Messung erfolgt insbesondere zu jedem Abtastschritt der nachfolgenden Auswertung. Die gemessene Spannung wird einem Transformationsblock 206 zugeführt, der eine Transformation dieser jeweils drei gemessenen Spannungswerte in Polarkoordinaten durchführt, die hier als $U_{\alpha,\,\beta}$ bezeichnet sind.

Die gemessene Spannung wird außerdem einem Frequenzbestimmungsblock 208 eingegeben, der aus den gemessenen Spannungswerten die Frequenz f, nämlich die Netzfrequenz des Versorgungsnetzes 202 bestimmt. Die Bestimmung der Frequenz erfolgt somit durch diesen Frequenzbestimmungsblock 208 durch einen vom Kalmanfilter unabhängigen Algorithmus. Hier kann beispielsweise ein Filter zur Bestimmung der Netzfrequenz aus einem Raumzeigerspannungswinkel verwendet werden. Vorzugsweise wird alternativ eine diskrete Fourier-Transformation der drei Spannungswerte verwendet, um einen gefilterten Winkel der Netzspannung zu bestimmen. Aus diesem kann wiederum durch geeignete Filterung ein Frequenzsignal extrahiert werden. Vorteil der Verwendung des aus der DFT gewonnenen Winkels gegenüber der Verwendung des Raumzeigerwinkels ist hierbei die Filterwirkung bei ganzzahligen Harmonischen der Grundfrequenz.

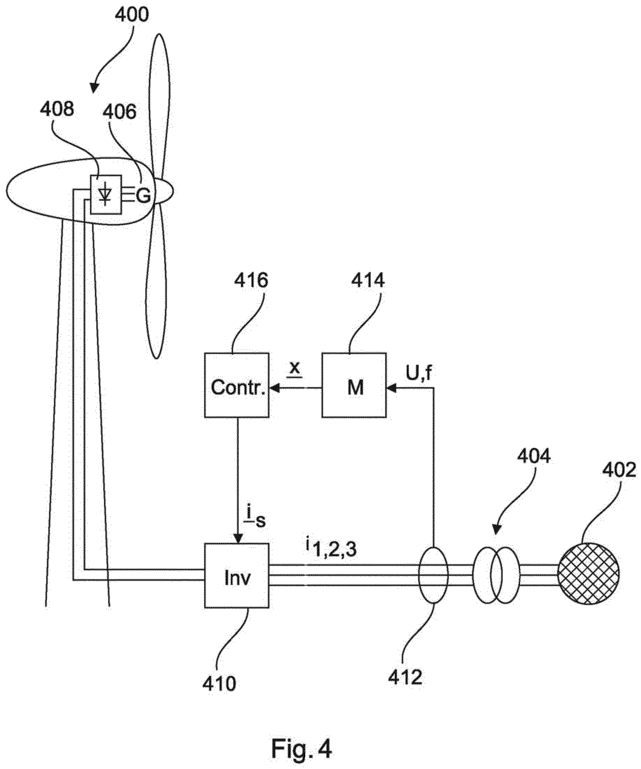

Es wird darauf hingewiesen, dass diese Blockdarstellung der Figur 2 und auch der Figur 3 und teilweise der Figur 4 der Veranschaulichung des eingesetzten Verfahrens dient. Die einzelnen Funktionen der dargestellten Blöcke müssen nicht zwangsläufig in einem solchen separaten Block durchgeführt werden, sondern können auch zusammen in einem Mikroprozessor oder einer anderen Recheneinheit realisiert sein.

Jedenfalls werden die transformierten Polarkoordinaten $U_{\alpha, \beta}$ und die erfasste Netzfrequenz f in den Kalman-Filterblock 210 eingegeben. Der Kalman-Filterblock 210 ist somit ein Filter, der als Ausgangsgröße die erfassten Zustände x bestimmt und ausgibt. Diese erfassten Zustände, die hier durch diesen Zustandsvektor x repräsentiert werden, können insbesondere Werte von Spannungszeigern für einen Gleichanteil, jeweils ein Mitsystem und ein Gegensystem der Grundschwingung und jeweils ein Mitsystem und ein Gegensystem jeder erfassten Oberschwingung beinhalten. Wird beispielsweise die Spannung bis zur Oberschwingung 25. Ordnung betrachtet, wobei die erste Ordnung die Grundschwingung wäre, kann dieser Zustandsvektor x 102 Werte umfassen. Diese Zahl ergibt sich aus zwei Werten für den Gleichanteil, nämlich Real- und Imaginärteil, welche als $u_{\alpha DC}$ und $u_{\beta DC}$ bezeichnet werden. Für die Grundschwingung und jede Oberschwingung ergeben sich je zwei Werte für das Mitsystem und zwei für das Gegensystem, nämlich jeweils Real- und Imaginärteil des Zeigers. Für die Grundschwingung, als erste Ordnung, sind das dann für das Mitsystem die Werte $u_{\alpha(1+)}$ und $u_{\beta(1+)}$ und entsprechend für das Gegensystem die Werte $u_{\alpha(1-)}$ und $u_{\beta(1-)}$. Sinngemäß können für jede weitere Ordnung auch vier Werte vorgesehen sein.

Diese Werte, also dieser so erfasste Zustandsvektor, können dann für eine Stromerzeugung zum Einspeisen elektrischen Stroms in das Versorgungsnetz 202 verwendet werden.

Details des Kalman-Filterblocks 210 sind in Figur 3 schematisch erläutert. Figur 3 zeigt also diesen Kalman-Filterblock 210 und der erhält, wie schon Figur 2 zu entnehmen ist, die gemessene und in Polarkoordinaten transformierte Spannung $U_{\alpha, \beta}$ sowie die durch den Frequenzbestimmungsblock 208 bestimmte Netzfrequenz f als Eingangsgrößen. Abhängig von dieser bestimmten Netzfrequenz f wird die Beobachtermatrix K in dem Beobachtermatrixblock 302 bestimmt und entsprechend als Beobachtermatrix K(f) ausgegeben. Der Beobachtermatrixblock 302 bestimmt diese Beobachtermatrix K dadurch, dass er in Abhängigkeit der Frequenz f die entsprechende Beobachtermatrix K aus einer Tabelle entnimmt. Ggf., wenn zu der exakten Frequenz keine Beobachtermatrix K hinterlegt ist, kann sie aus Beobachtermatrizen benachbarter Frequenzen durch Interpolation bestimmt werden.

Ebenfalls in Abhängigkeit der Frequenz wird die Systemmatrix A(f) in dem Systemmatrixblock 304 bestimmt. In dem Systemmatrixblock 304 wird dabei die Systemmatrix in bekannter Weise berechnet.

Die zu erfassenden Systemzustände x werden im Grunde in dem Updateblock 306 ständig neu berechnet. Dieser Updateblock 306 verhält sich dabei etwa wie ein systembeschreibendes Modell, wobei auch die jeweils aktuell gemessene und in Polarkoordinaten transformierte Spannung $U_{\alpha, \beta}$ zur Nachführung oder zum Abgleich, um es anschaulich auszudrücken, berücksichtigt wird.

Außerdem wird dafür auch die Beobachtermatrix K(f) benötigt, die der Updateblock 306 dafür immer aktuell von dem Beobachtermatrixblock 302 erhält. Eine das System beschreibende Matrix $\underline{C}$ wird ebenfalls benötigt und ist daher veranschaulichend als Eingang in den Updateblock 306 dargestellt.

Außerdem wird der aktualisierte Zustandsvektor $\underline{x}(k+1)$ benötigt. Dieser aktualisierte Zustandsvektor $\underline{x}(k+1)$ wird aus dem letzten Zustandsvektor $\underline{x}(k)$ und der Systemmatrix A(f) in dem Zustandsblock 308 berechnet. Der Zustandsblock 308 benötigt dafür die Systemmatrix A(f), die er jeweils aktuell von dem Systemmatrixblock 304 erhält. Den alten Zustandsvektor $\underline{x}(k)$ erhält der Zustandsblock 308 aktuell von dem Updateblock 306.

Der aktualisierte Zustandsvektor $\underline{x}(k+1)$ gilt somit ebenfalls, wie oben schon beschrieben, als Eingangsgröße für den Updateblock 306. Besonders zum Starten des Prozesses kann für diesen aktualisierten Zustandsvektor $\underline{x}(k+1)$ eine Initialisierung in dem Initialisierungsblock 310 vorgenommen werden.

Somit kann der Kalmanfilter 210 nun den jeweils erfassten Zustandsvektor $\underline{x}(k)$ als Zustandsvektor x ausgeben. Ggf. kann dieser noch einer Transformation, ggf. auch nur im Sinne einer Multiplikation mit einem konstanten Faktor in dem Transformationsblock 312, unterzogen werden. In dem Fall würde sich natürlich der in Figur 3 dargestellte Zustandsvektor x von dem internen Zustandsvektor $\underline{x}(k)$ entsprechend unterscheiden.

Dieser Zustandsvektor $\underline{x}$ kann nun Werte für Gleichanteil, Zeiger der Grundschwingung und Zeiger von Oberschwingungen enthalten, die zur Bestimmung einzuspeisender Ströme verwendet werden können. Dies ist in der Figur 4 veranschaulicht. Figur 4 veranschaulicht dies für eine Windenergieanlage 400, es können aber auch andere Einspeisevorrichtungen solche Messwerte aufnehmen und für eine Stromsteuerung, nämlich einzuspeisenden Stroms, verwenden.

Der Aufbau in Figur 4 veranschaulicht ein Versorgungsnetz 402, in das über einen Transformator 404 eingespeist wird. Dazu erzeugt die Windenergieanlage 400 mit einem Generator 406 elektrischen Strom, der in einem Gleichrichter 408 gleichgerichtet und einem Wechselrichter 410 zugeführt werden kann. Ein solcher Wechselrichter 410 wird auch häufig als Inverter 410 bezeichnet.

Dieser Wechselrichter 410 erzeugt einen dreiphasigen Strom $i_{1,2,3}$, der über diesen Transformator 404 in das Versorgungsnetz 402 eingespeist werden kann.

Es wird nun vorgeschlagen, mit einem symbolisch dargestellten Messaufnehmer 412 Spannung und Frequenz zu erfassen und einem Messblock 414 zuzuführen. Der Messblock 414 zusammen mit dem Messaufnehmer 412 kann der Messanordnung 201 der Figur 2 entsprechen. Die Frequenz f würde dann in dem Messblock 414 aus der erfassten Spannung erst bestimmt werden, aber zur Veranschaulichung ist in Figur 4 die Frequenz f auch als Eingangsgröße für den Messblock 414 eingezeichnet.

Der Messblock 414 kann dann als Ausgangsgröße den Zustandsvektor x ausgeben, der Werte für Gleichanteil, Grundschwingung und Oberschwingung enthalten kann, insbesondere auch jeweils für Mit- und Gegensystem, wie oben zur Figur 2 erläutert wurde.

Diese Werte, also der Zustandsvektor $\underline{x}$, können dann in den Steuerblock 416 eingegeben werden, der beispielsweise einen Controller enthalten kann. In diesem Steuerblock 416 können auch abhängig der erfassten Spannungswerte, die also in dem Zustandsvektor $\underline{x}$ enthalten sind, für jede Oberschwingung Abweichungen berechnet werden und daraus können die entsprechenden Stromwerte bestimmt werden. Insbesondere wird aus den Abweichungen oder anderweitig aus den erfassten Oberschwingungen der Spannung jeweils, also für jede Oberschwingung, ein Kompensationsstromanteil bestimmt. Dieser eine Kompensationsstromanteil oder diese mehren Kompensationsstromanteile werden dann dem Stromwert für die Grundschwingung, mit dem nämlich elektrische Leistung, ggf. auch elektrische Blindleistung, eingespeist werden soll, überlagert.

Der Steuerblock 416 bestimmt dann schließlich Stromsollwerte $i_s$, die als solche in den Wechselrichter 410 eingegeben werden. Diese Stromsollwerte berücksichtigen den einzuspeisenden Strom nebst Überlagerung, also Grundschwingung und Oberschwingung(en). Der Wechselrichter 410 kann dann basierend auf diesen Stromsollwerten $i_s$ die entsprechenden Stromwerte erzeugen. Alternativ kann vorgesehen sein, die Grundschwingung des einzuspeisenden Stroms und die wenigstens eine zu überlagernde Oberschwingung getrennt zu erzeugen und dann zu überlagern, also zu addieren. Dazu wird vorgeschlagen, mehrere Wechselrichter vorzusehen, von denen wenigstens einer die Grundschwingung oder einen Teil davon erzeugt und von denen wenigstens ein anderer die wenigstens eine Oberschwingung oder einen Teil davon erzeugt.

Die Erfindungsidee zeichnet sich somit insbesondere durch das Folgende aus.

In modernen Energiesystemen sind Erzeugungseinheiten und Verbraucher in zunehmendem Maße über Frequenzumrichter bzw. Gleichrichter an das Übertragungs- oder Verteilnetz angeschlossen. Durch die schaltenden Komponenten dieser leistungselektronischen Systeme entsteht eine Verunreinigung der im idealen Fall sinusförmigen 50 Hz- oder 60 Hz-Wechselspannung durch Oberschwingungen im Frequenzbereich bis zu etwa 10 kHz. Diese Oberschwingungen wirken belastend auf verschiedene Betriebsmittel in den Energiesystemen und werden daher bei zu hohem Aufkommen durch aktive oder passive Filter bedämpft.

Windenergieanlagen stellen in einigen Energiesystemen schon einen signifikanten Teil der erzeugten Energie zur Verfügung. Überwiegend sind sie durch Frequenzumrichter mit dem Netz verbunden und tragen somit im schlimmsten Fall ebenfalls zu Oberschwingungen im Netz bei.

Die hier beschriebene Erfindung bezieht sich auf ein Verfahren zur Erkennung und Kompensation von Oberschwingungen in der Netzspannung eines Energiesystems durch eine an dieses System über einen Vollumrichter angeschlossene Windenergieanlage. Die Windenergieanlage (WEA) wird somit in die Lage versetzt, einen Strom einzuspeisen um Spannungsoberschwingungen oder Gegensystemspannungen zu verringern. Diese können z.B. durch andere Erzeugungseinheiten oder Verbraucher hervorgerufen werden.

Zu diesem Zweck wird besonders folgendes Verfahren vorgeschlagen:

1. Messung der Klemmenspannungen windenergieanlagenseitig am Anlagentransformator.

2. Umwandlung der drei Klemmenspannungen in einen rotierenden Spannungszeiger mit der Clarke-Transformation unter Annahme der Nullsystemfreiheit der Spannungen, wobei der Spannungszeiger durch Betrag und Phase gegeben ist.

3. Anwendung eines Filters zur Beobachtung von Gleichanteil, sowie Mit- und Gegensystemspannungen von vielfachen der Netzfrequenz von der 1. Ordnung, also der Grundschwingung, bis zu einer definierten höchstmöglichen Oberschwingungsordnung. Hierbei ist ein weiterer Eingang in den Filter eine anderweitig bestimmte Netzfrequenz. Der Filter kann als Zustandsbeobachter, insbesondere Kalmanfilter ausgebildet sein.

4. Berechnung eines gewünschten Kompensationsstroms in für die Kompensation ausgewählten Oberschwingungsordnungen über ein Steuer- oder Regelgesetz. Vorzugsmäßig erfolgt die Einstellung über einen proportionalen Faktor $k_i$, der für die i. Ordnung der Spannung einen auszubringenden Kompensationsstrom in Höhe von $k_i$ A je V Spannungsoberschwingungsamplitude definiert. Eine weitere bevorzugte Berechnung des Kompensationsstromes stellt die Berechnung durch Anwendung eines PID-Reglers auf die Differenz zwischen einer Sollspannung, z.B. 0 V, und der Ist-Spannung der entsprechenden Komponente dar. Bei ausreichender Stromstellfähigkeit des Umrichters kann somit - idealer Weise - eine komplette Ausregelung von Oberschwingungs- oder Gegensystemspannungen erfolgen.

5. Einstellung des Kompensationsstroms zusätzlich zum gewünschten Wirk- und Blindstrom in der Grundschwingung über ein Stromregelverfahren. Vorzugsweise wird ein Hysteresestromregler, auch als Toleranzbandregler bezeichnet, verwendet, da hier sehr schnelle Reaktionszeiten und eine hohe Robustheit gegenüber veränderlichen Netzparametern erzielt werden können.

Besonderes Augenmerk muss auf die geeignete Filterung der Spannungszeiger zur schnellen und präzisen Ermittlung von korrekten Spannungsamplituden in den verschiedenen Frequenzbereichen, nämlich Gleichspannungen, Grundschwingung und Oberschwingungen, gelegt werden.

Bestehende Verfahren zur Ermittlung von Oberschwingungskomponenten in der Spannung basieren häufig auf rekursiv formulierten diskreten Fourier-Transformationen der Messgrößen. Diese zeichnen sich durch eine hohe numerische Robustheit aus. Jedoch ist die Filtergüte nur dann sichergestellt, wenn die Abtastfrequenz ein ganzzahliges Vielfaches der Grundschwingungsfrequenz des Messsignals bzw. des Abstands zwischen zwei zu identifizierenden Frequenzkomponenten beträgt. Da im Allgemeinen die Netzfrequenz in einem Energiesystem leichten Schwankungen unterworfen ist und darüber hinaus die Einsetzbarkeit eines Verfahrens in Systemen mit unterschiedlicher Nennfrequenz (z.B. 50 und 60 Hz) einen Vorteil darstellt, ist eine hohe Filterqualität bei unterschiedlichen Netzfrequenzen und gleichbleibender Abtastrate von großer Wichtigkeit für den weitest möglichen Einsatz.

Verschiedene Lösungen sind für dieses Problem bekannt, die jedoch alle mit zum Teil erheblichen Nachteilen behaftet sind. Eine Möglichkeit besteht in der Veränderung der Abtastrate des Algorithmus in Abhängigkeit der Netzfrequenz, wie der Referenz [1] zu entnehmen ist. Häufig ist eine solche Veränderung der Abtastrate jedoch nicht gewünscht, da auf der Recheneinheit noch andere Algorithmen ausgeführt werden, für die eine feste Abtastrate von Bedeutung ist, wie dies z.B. bei einem zeitdiskret ausgelegten Regler der Fall ist. Eine weitere Möglichkeit besteht in der Ausführung einer Phasen- oder Frequenzregelschleife, wie der Referenz [2] zu entnehmen ist. Bei diesen Algorithmen sind jedoch entweder mangelnde Filterwirkung bei abnormalen Netzzuständen zu beobachten, besonders im Zusammenhang mit einer Phasenregelschleife, oder es sind insbesondere bei niedrigen Abtastraten in der digitalen Implementierung erhebliche Stabilitätsprobleme zu beobachten, besonders im Zusammenhang mit einer Frequenzregelschleife.

Eine dritte Lösungskategorie stellen Kalman-Filter dar, die auf Basis von Zustandsraummodellen der Dynamik der Netzspannungen ausgelegt werden. Hierbei kann unterschieden werden zwischen Filtern für konstante Netzfrequenz, wie der Referenz [3] zu entnehmen ist, bei denen sich eine lineare Dynamik ergibt, sowie Filtern für variable Netzfrequenz, wie der Referenz [4] zu entnehmen ist, denen nichtlineare Differentialgleichungen zugrunde liegen. Letztere Filter berechnen die unter den gegebenen Rauschparametern optimale Beobachtermatrize rekursiv, in dem in jedem Zeitschritt eine auf den aktuellen Zustandsgrößen basierende Zustandsraumbeschreibung in den Synthesegleichungen verwendet wird. Bei entsprechender Parametrierung ergeben sich hierbei hervorragende Filtereigenschaften auch bei variierender Netzfrequenz sowie unter abnormalen Netzbedingungen wie z.B. unsymmetrischen oder stark mit Oberschwingungen belasteten Spannungen, da alle diese Effekte in der Zustandsraumbeschreibung des Systems berücksichtigt werden können.

Ein Nachteil der Methode des erweiterten Kalman-Filters zur Beobachtung von Zustandsgrößen eines nichtlinearen Systems ist jedoch die rekursive Berechnung der Beobachtermatrize. Hierfür sind in jedem Rechenschritt mehrere Multiplikationen der Matrizen der Zustandsraumbeschreibungen untereinander sowie mit Vektoren der Mess- und Zustandsgrößen notwendig. Bei einer hohen Filterdimension zur Berücksichtigung zahlreicher Oberschwingungsordnungen wirkt sich dies negativ auf die benötigten Rechenzeiten aus. Bei beschränkter Rechenkapazität ist eine Ausführung innerhalb der durch die Abtastrate begrenzten Zykluszeit unter Umständen nicht mehr möglich.

Demgegenüber besteht unter der Annahme von konstanter Netzfrequenz die Möglichkeit der Vorberechnung der Beobachtermatrize für das Kalman-Filter durch Lösung einer algebraischen Riccati- Gleichung, bedingt durch die zeitinvarianten und linearen Systemgleichungen in diesem Fall, was der Referenz [3] zu entnehmen ist. Gemäß wenigstens einer Ausführungsform wird hier das Vorberechnen der Beobachtermatrix vorgeschlagen, für verschiedene Netzfrequenzen.

Nach Referenz [3] wird folgendes frequenzabhängiges Differenzengleichungssystem als Grundlage für die Herleitung der Beobachterimplementierung verwendet:

$$x(k + 1) = A(f)x(k)$$

$$y(k) = Cx(k)$$

$$A(f) = \begin{bmatrix} & & 0 & 0 & 0 & 0 & & 0 & 0 & 0 & 0 & 0 & 0 \\ & A_1(f) & 0 & 0 & 0 & 0 & & 0 & 0 & 0 & 0 & 0 & 0 \\ & & 0 & 0 & 0 & 0 & & 0 & 0 & 0 & 0 & 0 & 0 \\ & & 0 & 0 & 0 & 0 & & 0 & 0 & 0 & 0 & 0 & 0 \\ 0 & 0 & 0 & 0 & & & \cdots & 0 & 0 & 0 & 0 & 0 & 0 \\ 0 & 0 & 0 & 0 & & & & 0 & 0 & 0 & 0 & 0 & 0 \\ 0 & 0 & 0 & 0 & & A_2(f) & & 0 & 0 & 0 & 0 & 0 & 0 \\ 0 & 0 & 0 & 0 & & & & 0 & 0 & 0 & 0 & 0 & 0 \\ & & \vdots & & & & \ddots & & & & & \vdots & \\ 0 & 0 & 0 & 0 & 0 & 0 & 0 & 0 & & & & 0 & 0 \\ 0 & 0 & 0 & 0 & 0 & 0 & 0 & 0 & & & & 0 & 0 \\ 0 & 0 & 0 & 0 & 0 & 0 & 0 & 0 & & A_N(f) & & 0 & 0 \\ 0 & 0 & 0 & 0 & 0 & 0 & 0 & 0 & & & & 0 & 0 \\ 0 & 0 & 0 & 0 & 0 & 0 & 0 & 0 & & & & 1 & 0 \\ 0 & 0 & 0 & 0 & 0 & 0 & 0 & 0 & \cdots & 0 & 0 & 0 & 1 \end{bmatrix}$$

$$A_i(f) = \begin{bmatrix} \cos(2\pi T_s if) & -\sin(2\pi T_s if) & & 0 \\ \sin(2\pi T_s if) & \cos(2\pi T_s if) & & \\ & 0 & \cos(2\pi T_s if) & \sin(2\pi T_s if) \\ & & -\sin(2\pi T_s if) & \cos(2\pi T_s if) \end{bmatrix}$$

$$C = \begin{bmatrix} \begin{pmatrix} 1 & 0 \\ 0 & 1 \end{pmatrix}_1 & \cdots & \begin{pmatrix} 1 & 0 \\ 0 & 1 \end{pmatrix}_{N+1} \end{bmatrix}$$

$$x(k) = \begin{bmatrix} x_1(k) & x_2(k) & \ldots & x_N(k) & u_{DC\alpha}(k) & u_{DC\beta}(k) \end{bmatrix}^T$$

$$x_i(k) = \begin{bmatrix} u_{i(1)\alpha}(k) & u_{i(1)\beta}(k) & u_{i(2)\alpha}(k) & u_{i(2)\beta}(k) \end{bmatrix}$$

$$y(k) = \begin{bmatrix} u_\alpha(k) & u_\beta(k) \end{bmatrix}^T$$

In diesen Gleichungen bezeichnet k den aktuellen Ausführungsschritt, $T_s$ die Abtastzeit der diskreten Implementierung des Algorithmus, f die Netzfrequenz, i einen Index, der Werte von 1 bis zu der Zahl der im Beobachter berechneten höchsten Oberschwingungsordnung N annimmt, $u_{DC\alpha}(k)/u_{DC\beta}(k)$ die Alpha- und Beta-Gleichspannungskomponenten, $u_{i(1)\alpha}(k)/u_{i(1)\beta}(k)$ die Alpha- bzw. Beta-Mitsystemspannungskomponenten der i. Ordnung (d.h. bei i = 1 Grundschwingung, bei i > 1 Oberschwingungskomponenten) und $u_{i(2)\alpha}(k)/u_{i(2)\beta}(k)$ die Alpha- bzw. Beta-Gegensystemspannungskomponenten der i. Ordnung.

Auf Grundlage dieser Gleichungen kann für jede Netzfrequenz f eine Beobachtermatrize K berechnet werden, die dann in einer Standard-Beobachterimplementierung zur Beobachtung der Zustände verwendet werden kann. Die Gleichung zur Berechnung der Kalman-Beobachtermatrize unter Verwendung der Zustands- und Messsignalrauschkovarianzmatrizen Q und R ist bekannt, z.B. aus der Referenz [6].

Unter Verwendung der Matrize K erfolgt das Update der Zustandsschätzung in jedem Zeitschritt nach der bekannten Gleichung

$$x(k|k) = x(k|k-1) + K * \left( y(k) - C * x(k|k-1) \right)$$

Hierin bezeichnet x(k|k) die Zustandsschätzung aus dem aktuellen Zeitschritt und x(klk-1) die Zustandsschätzung für den aktuellen Zeitschritt aus dem letzten Zeitschritt.

Erfindungsgemäß wird, zumindest gemäß einer Ausführungsform, in dem hier verwendeten Verfahren die Beobachtermatrize, was synonym auch als Beobachtermatrix bezeichnet wird, für eine gegebene Zustandsraumbeschreibung und definierte Mess- und Zustandsrauschpegel für verschiedene, den gesamten gewünschten Betriebsbereich umfassende Netzfrequenzen vorberechnet. Zur Ausführungszeit erfolgt die Bestimmung der Frequenz durch einen vom Kalman-Filter unabhängigen Algorithmus. Ein solcher kann durch einen Block Frequenzbestimmung umgesetzt werden, wie einer in den Figuren dargestellt ist. Hier kann z.B. ein geeigneter Filter zur Bestimmung der Netzfrequenz aus einem Raumzeigerspannungswinkel verwendet werden. Dieses Frequenzsignal dient zur Auswahl einer zu dieser Frequenz passenden Beobachtermatrize. Hierbei kann zur Erhöhung der Auflösung zwischen verschiedenen gespeicherten Beobachtermatrizen bei unterschiedlichen Frequenzen interpoliert werden.

Somit lässt sich mit diesem Verfahren eine präzise, schnelle Berechnung zahlreicher Oberschwingungen der Netzspannung im Mit- und Gegensystem mit gegenüber dem nichtlinearen, erweiterten Kalman- Filter erheblich verringertem Rechenaufwand erzielen. Anders als bei der Anwendung von Frequenzregelschleifen, wie z.B. auch in Referenz [5] unter Nutzung eines Kalman-Filters beschrieben ist, verwendet der hier beschriebene Algorithmus keine geschlossene Schleife zur Bestimmung der Netzfrequenz, die durch ihre schwer zu analysierende nichtlineare Dynamik stets ein Stabilitätsrisiko für den Filteralgorithmus darstellt. Vielmehr wird die Netzfrequenz gesondert bestimmt und nur zur Auswahl der Beobachtermatrize verwendet.

Weiterhin kann das oben beschriebene Verfahren auch zur Bestimmung von Oberschwingungen im Strom verwendet werden.

Die oben genannten Referenzen sind die Folgenden:

[1] B. P. McGrath, D. G. Holmes, J. Galloway: Improved Power Converter Line Synchronisation using an Adaptive Discrete Fourier Transform (DFT). Proceedings of IEEE 33rd Annual Power Electronics Specialists Conference, 2002, Bd. 2, S. 821-826.

[2] R. Teodorescu, M. Liserre, P. Rodriguez: Grid Converters for Photovoltaic and Wind Power Systems. John Wiley & Sons, Chichester, 2011.

[3] R. R. Bitmead, A. C. Tsoi, P. J. Parker: A Kalman Filtering Approach to Short-Time Fourier Analysis. IEEE Transactions on Acoustics, Speech and Signal Processing, Bd. ASSP-34(6), Dezember 1986, S. 1493- 1501.

[4] B. La Scala, R. R. Bitmead: Design of an Extended Kalman Filter Frequency tracker. IEEE Transactions on Signal Processing, Bd. 44(3), März 1996, S. 739-742.

[5] M. S. Reza, M. Ciobotaru, V. G. Agelidis: Instantaneous Power Quality Analysis Using Frequency Adaptive Kalman Filter Technique. Proceedings of 7th International Power Electronics and Motion Control Conference, Harbin, China, Juni 2012, S. 81-87.

[6] T. Glad, L. Ljung: Control Theory. Taylor & Francis, London, 2000.

**Patentansprüche**

1. Verfahren zum Einspeisen elektrischen Stroms in ein elektrisches, dreiphasiges Versorgungsnetz umfassend die Schritte:

   - Erfassen einer elektrischen , dreiphasigen Spannung in dem Versorgungsnetz nach Betrag und Phase für eine Grundschwingung und wenigstens eine Oberschwingung umfassend die Schritte:

      - Messen der elektrischen, dreiphasigen Spannung des Versorgungsnetzes,
      - Transformieren der gemessenen Spannungswerte in Polarkoordinaten mit einem umlaufenden Spannungszeiger für die Grundschwingung als gemessenen Referenzzeiger,

         - wobei die Transformation der gemessenen Spannung in Polarkoordinaten mit Hilfe der Clark-Transformation unter Annahme der Nullsystemfreiheit der Spannung durchgeführt wird,
         - Beobachten von Werten jeweils wenigstens eines Spannungszeigers für die Grundschwingung und wenigstens eines Spannungszeigers für wenigstens eine zu erfassende Oberschwingung mit Hilfe eines Zustandsbeobachters, und
         - Nachführen der beobachteten Werte in Abhängigkeit des gemessenen Referenzzeigers und

   - Erzeugen eines elektrischen Stroms zum Einspeisen in das elektrische Versorgungsnetz, wobei der elektrische Strom eine Kompensationsstromkomponente beinhaltet, um die wenigstens eine erfasste Oberschwingung zu reduzieren.

2. Verfahren nach Anspruch 1, **dadurch gekennzeichnet, dass** der Zustandsbeobachter in Abhängigkeit einer erfassten Netzfrequenz arbeitet und die erfasste Netzfrequenz in den Zustandsbeobachter als Eingangsgröße eingegeben wird.

**3.** Verfahren nach Anspruch 1 oder 2, **dadurch gekennzeichnet, dass** der Zustandsbeobachter die Werte der Spannungszeiger mit Hilfe einer aktuellen Beobachtermatrix beobachtet und die aktuelle Beobachtermatrix aus mehreren vorberechneten Beobachtermatrizen in Abhängigkeit der erfassten Netzfrequenz ausgewählt wird.

**4.** Verfahren nach einem der vorstehenden Ansprüche, **dadurch gekennzeichnet, dass** als Zustandsbeobachter ein Kalmanfilter verwendet wird.

**5.** Verfahren nach einem der vorstehenden Ansprüche, **dadurch gekennzeichnet, dass** für die Grundschwingung und für jede zu erfassende Oberschwingung jeweils ein Mitsystem und ein Gegensystem durch den Zustandsbeobachter erfasst wird und dass optional ein Gleichanteil erfasst wird.

**6.** Verfahren nach einem der vorstehenden Ansprüche, **dadurch gekennzeichnet, dass** für die Grundschwingung und für jede zu erfassende Oberschwingung jeweils ein Spannungszeiger für ein Mitsystem und einer für ein Gegensystem zu Grunde gelegt wird und dessen Werte beobachtet werden und dass optional für einen Gleichanteil ein Spannungszeiger zu Grunde gelegt und dessen Werte erfasst werden.

**7.** Verfahren nach einem der vorstehenden Ansprüche, **dadurch gekennzeichnet, dass** die Messung der elektrischen, dreiphasigen Spannung des Versorgungsnetzes an einem an das elektrische Versorgungsnetz angeschlossenem Transformator erfolgt, insbesondere an der Seite des Transformators, die elektrisch einer über diesen Transformator in das elektrische Versorgungsnetz einspeisenden Windenergieanlage zugewandt ist.

**8.** Verfahren nach einem der vorstehenden Ansprüche, **dadurch gekennzeichnet, dass** die Kompensationsstromkomponente wenigstens eine Stromoberschwingung aufweist und eine Stromoberschwingung jeweils durch eine Amplitude und eine Phase und in Abhängigkeit der beobachteten Oberschwingungen der erfassten Spannung bestimmt wird.

**9.** Verfahren nach einem der vorstehenden Ansprüche, **dadurch gekennzeichnet, dass** jeweils eine Amplitude einer Stromoberschwingung der Kompensationsstromkomponente über einen Regler eingestellt wird, und der Regler als Eingangssignal eine Regeldifferenz zwischen Spannungssollwert und beobachtetem Spannungsistwert der betreffenden Oberschwingung der erfassten Spannung erhält.

**10.** Verfahren nach Anspruch 9, **dadurch gekennzeichnet, dass** als Regler ein Regler ausgewählt wird aus der Liste umfassend

- PID-Regler,
- PI-Regler,
- P- Regler und
- PD-Regler.

**11.** Verfahren nach einem der vorstehenden Ansprüche, **dadurch gekennzeichnet, dass** die Kompensationsstromkomponente Stromoberschwingungen jeweils als Mit- und Gegensystemkomponenten berücksichtigt.

**12.** Windenergieanlage mit einem Wechselrichter zum Erzeugen eines in ein dreiphasiges elektrisches Stromnetz einzuspeisenden elektrischen Stroms, wobei die Windenergieanlage dazu vorbereitet ist, ein Verfahren nach einem der Ansprüche 1 bis 11 auszuführen.

**Claims**

**1.** Method for feeding electrical current into an electrical three-phase supply network, comprising the steps of: recording the magnitude and phase of a electrical three-phase voltage in the supply network for a fundamental and at least one harmonic, comprising the steps of:

- measuring the electrical three-phase voltage of the supply network,
- transforming the measured voltage values into polar coordinates using a rotating voltage phasor for the fundamental as a measured reference phasor,

- wherein the measured voltage is transformed into polar coordinates with the aid of the Clarke transformation assuming that the voltage is free of the zero-sequence system,

- respectively observing values of at least one voltage phasor for the fundamental and of at least one voltage phasor for at least one harmonic to be recorded with the aid of a state observer, and
- tracking the observed values on the basis of the measured reference phasor and
- producing an electrical current for feeding into the electrical supply network, the electrical current comprising a compensation current component in order to reduce the at least one recorded harmonic.

2. Method according to Claim 1, **characterized in that** the state observer operates on the basis of a recorded network frequency and the recorded network frequency is input to the state observer as an input variable.

3. Method according to Claim 1 or 2, **characterized in that** the state observer observes the values of the voltage phasors with the aid of an up-to-date observer matrix and the up-to-date observer matrix is selected from a plurality of pre-calculated observer matrices on the basis of the recorded network frequency.

4. Method according to one of the preceding claims, **characterized in that** a Kalman filter is used as the state observer.

5. Method according to one of the preceding claims, **characterized in that** a positive-sequence system and a negative-sequence system are respectively recorded by the state observer for the fundamental and for each harmonic to be recorded, and **in that** a DC component is optionally recorded.

6. Method according to one of the preceding claims, **characterized in that** a voltage phasor for a positive-sequence system and a voltage phasor for a negative-sequence system are respectively taken as a basis for the fundamental and for each harmonic to be recorded and their values are observed, and **in that** a voltage phasor is optionally taken as a basis for a DC component and its values are recorded.

7. Method according to one of the preceding claims, **characterized in that** the electrical three-phase voltage of the supply network is measured at a transformer connected to the electrical supply network, in particular on that side of the transformer which electrically faces a wind power installation which feeds the electrical supply network via this transformer.

8. Method according to one of the preceding claims, **characterized in that** the compensation current component has at least one current harmonic and a current harmonic is respectively determined by an amplitude and a phase and on the basis of the observed harmonics of the recorded voltage.

9. Method according to one of the preceding claims, **characterized in that** an amplitude of a current harmonic of the compensation current component is respectively adjusted using a controller, and the controller receives, as an input signal, a control difference between the desired voltage value and the observed actual voltage value of the relevant harmonic of the recorded voltage.

10. Method according to Claim 9, **characterized in that**, as the controller, a controller is selected from the list comprising

- PID controller,
- PI controller,
- P controller, and
- PD controller.

11. Method according to one of the preceding claims, **characterized in that** the compensation current component respectively takes into account current harmonics as positive-sequence system and negative-sequence system components.

12. Wind power installation having an inverter for producing an electrical current to be fed into a three phase electrical power supply system wherein the wind power installation is prepared to carry out a method according to one of Claims 1 to 11.

**Revendications**

1. Procédé d'injection de courant électrique dans un réseau d'alimentation électrique triphasé comprenant les étapes :

   - de détection d'une tension électrique triphasée dans le réseau d'alimentation selon l'ampleur et la phase pour une oscillation fondamentale et au moins un harmonique, comprenant les étapes :
   - de mesure de la tension électrique triphasée du réseau d'alimentation,
   - de transformation des valeurs de tension mesurées en coordonnées polaires avec un indicateur de tension circulaire pour l'oscillation fondamentale comme indicateur de référence mesuré,
   - dans lequel la transformation de la tension mesurée en coordonnées polaires est réalisée à l'aide de la transformée de Clark en supposant la liberté de système homopolaire de la tension,
   - d'observation des valeurs respectivement d'au moins un indicateur de tension pour l'oscillation fondamentale et d'au moins un indicateur de tension pour au moins un harmonique à détecter à l'aide d'un observateur d'état, et
   - de suivi des valeurs observées en fonction de l'indicateur de référence mesuré et
   - de génération d'un courant électrique destiné à être injecté dans le réseau d'alimentation électrique, dans lequel le courant électrique comporte une composante de courant de compensation pour réduire l'au moins un harmonique détecté.

2. Procédé selon la revendication 1, **caractérisé en ce que** l'observateur d'état fonctionne en fonction d'une fréquence de réseau détectée et la fréquence de réseau détectée est entrée dans l'observateur d'état comme grandeur d'entrée.

3. Procédé selon la revendication 1 ou 2, **caractérisé en ce que** l'observateur d'état observe les valeurs des indicateurs de tension à l'aide d'une matrice d'observateur actuelle et la matrice d'observateur actuelle est sélectionnée parmi plusieurs matrices d'observateur précalculées en fonction de la fréquence de réseau détectée.

4. Procédé selon l'une quelconque des revendications précédentes, **caractérisé en ce qu'**un filtre de Kalman est utilisé comme observateur d'état.

5. Procédé selon l'une quelconque des revendications précédentes, **caractérisé en ce que**, pour l'oscillation fondamentale et pour chaque harmonique à détecter, un système direct et un système inverse sont respectivement détectés par l'observateur d'état et qu'une composante continue est éventuellement détectée.

6. Procédé selon l'une quelconque des revendications précédentes, **caractérisé en ce que**, pour l'oscillation fondamentale et pour chaque harmonique à détecter, respectivement un indicateur de tension sert de base à un système direct et un indicateur de tension à un système inverse et leurs valeurs sont observées et que facultativement un indicateur de tension sert de base à une composante continue et ses valeurs sont détectées.

7. Procédé selon l'une quelconque des revendications précédentes, **caractérisé en ce que** la mesure de la tension électrique triphasée du réseau d'alimentation s'effectue sur un transformateur raccordé au réseau d'alimentation électrique, notamment du côté du transformateur qui est électriquement orienté vers une éolienne alimentant le réseau d'alimentation électrique par l'intermédiaire de ce transformateur.

8. Procédé selon l'une quelconque des revendications précédentes, **caractérisé en ce que** la composante de courant de compensation présente au moins un harmonique de courant et qu'un harmonique de courant est déterminé respectivement par une amplitude et une phase et en fonction des harmoniques observés de la tension détectée.

9. Procédé selon l'une quelconque des revendications précédentes, **caractérisé en ce qu'**une amplitude d'un harmonique de courant de la composante de courant de compensation est à chaque fois réglée par l'intermédiaire d'un régulateur, et le régulateur reçoit comme signal d'entrée une différence de régulation entre la valeur de consigne de tension et la valeur réelle de tension observée de l'harmonique concerné de la tension détectée.

10. Procédé selon la revendication 9, **caractérisé en ce qu'**un régulateur est sélectionné comme régulateur dans la liste comprenant

    - un régulateur PID,
    - un régulateur PI,
    - un régulateur P et
    - un régulateur PD.

**11.** Procédé selon l'une quelconque des revendications précédentes, **caractérisé en ce que** la composante de courant de compensation prend en compte respectivement les harmoniques de courant comme composantes des systèmes direct et inverse.

**12.** Éolienne avec un onduleur pour générer un courant électrique destiné à être injecté dans un réseau électrique triphasé, dans laquelle l'éolienne est destinée à mettre en œuvre un procédé selon l'une quelconque des revendications 1 à 11.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8981755 B
- US 20130141951 A
- US 6924627 B
- WO 2009056158 A1
- US 2012150468 A1
- DE 10032447 A1
- US 20120150468 A1
- US 20140307488 A1
- EP 2223405 B1


**In der Beschreibung aufgeführte Nicht-Patentliteratur**

- **AZAM BAGHERI et al.** *Detection of Grid Voltage Fundamental and Harmonic Components Using Kalman Filter and Generalizied Averaging Method*
- **MING SUN et al.** *Extended Kalman Filter Based Grid Synchronization in the Presence of Voltage Unbalance for Smart Grid*
- **ROBERT R. BITMEAD et al.** *A Kalman Filtering Approach to Short-Time Fourier Analysis*
- **B. P. MCGRATH** ; **D. G. HOLMES** ; **J. GALLOWAY**. Improved Power Converter Line Synchronisation using an Adaptive Discrete Fourier Transform (DFT). *Proceedings of IEEE 33rd Annual Power Electronics Specialists Conference*, 2002, vol. 2, 821-826
- **R. TEODORESCU** ; **M. LISERRE** ; **P. RODRIGUEZ**. Grid Converters for Photovoltaic and Wind Power Systems. John Wiley & Sons, 2011
- **R. R. BITMEAD** ; **A. C. TSOI** ; **P. J. PARKER**. A Kalman Filtering Approach to Short-Time Fourier Analysis. *IEEE Transactions on Acoustics, Speech and Signal Processing*, December 1986, vol. ASSP-34 (6), 1493-1501
- **B. LA SCALA** ; **R. R. BITMEAD**. Design of an Extended Kalman Filter Frequency tracker. *IEEE Transactions on Signal Processing*, March 1996, vol. 44 (3), 739-742
- **M. S. REZA** ; **M. CIOBOTARU** ; **V. G. AGELIDIS**. Instantaneous Power Quality Analysis Using Frequency Adaptive Kalman Filter Technique. *Proceedings of 7th International Power Electronics and Motion Control Conference, Harbin, China*, June 2012, 81-87
- **T. GLAD** ; **L. LJUNG**. Control Theory. Taylor & Francis, 2000